# FASCICULE DE BREVET EUROPEEN

(11) **EP 0 406 795 B1**
(45) Date de publication et mention de la délivrance du brevet: **24.05.1995**
(21) Numéro de dépôt: 90112673.0
(22) Date de dépôt: 03.07.1990
(51) Int. Cl.: H01L 39/24, H01L 39/14

(54) **Brin supraconducteur multifilamentaire destiné aux fréquences industrielles**
Mehrfaseriger, supraleitender Draht für industrielle Frequenzen
Multifilament superconductor wire for use at industrial frequencies

(30) Priorité: 06.07.1989 FR 8909120
(43) Date de publication de la demande: 09.01.1991
(73) Titulaire: GEC ALSTHOM SA, 75116 Paris (FR)
(72) Inventeur: Cave, Julian c/o Laboratoires de Marcoussis, F-91460 Marcoussis (FR); Verhaege, Thierry, F-91160 Saulx Les Chartreux (FR)
(74) Mandataire: Weinmiller, Jürgen

(56) Documents cités:
- IEEE TRANSACTIONS ON MAGNETICS. vol. 24, no. 2, mars 1988, NEW YORK US pages 1033-1036; T.S.Kreilick et al.: "Influence of filament spacing and matrix material on the attainment of high quality uncoupled NbTi fine filaments."
- IEEE TRANSACTIONS ON MAGNETICS. vol. 24, no. 2, mars 1988, NEW YORK US pages 1145-1148; A.K.Ghosh et al.: "The effect of magnetic impurities and barriers on the magnetization and critical current of fine filament NbTi composits."
- CRYOGENICS, vol. 25, n 10, 1985, Oct., Guilford, Surrey, GB, pages 558-565; I. HLANISK et al. : "Properties of superconducting NbTi superfine filament composites with diameters = 0.1 m"

## Description

La présente invention concerne un brin surpraconducteur multifilamentaire, destiné aux fréquences industrielles.

L'assemblage d'un nombre élevé de tels brins permet d'obtenir un conducteur. Un brin est lui-même constitué par un assemblage d'un très grand nombre de filaments supraconducteurs séparés les uns des autres par un matériau de séparation non supraconducteur. L'article "Cryogenics vol 25 n°10, 1985 Oct. Guilford Suney GB, pages 558-565", décrit un tel brin.

Il est connu que des filaments supraconducteurs, en particulier de niobium-titane, peuvent transporter des densités de courant très élevées, de l'ordre de 10000 A/mm2 et que des conducteurs réalisés à base de ces filaments peuvent présenter de faibles pertes en régime alternatif, aux conditions suivantes.
1) que les filaments soient ultra-fins : moins de 0,2 »m de diamètre, continus, c'est-à-dire non coupés et de section régulière,
2) que les filaments soient séparés par un matériau capable de réduire suffisamment les effets de proximité qui se traduisent par le passage de supra-courants entre les filaments .
3) que ce matériau, séparant les filaments, soit fortement résistif pour limiter les pertes par courants induits.
4) que les filaments soient finement transposés.

Il est connu actuellement de réaliser un brin supraconducteur multifilamentaire à partir d'une billette de départ constituée par une âme en alliage de niobium et de titane disposée à l'intérieur d'une matrice en alliage de cuivre et de nickel, une feuille en niobium étant interposée entre l'âme et la matrice et servant de barrière contre la diffusion du matériau de la matrice vers l'âme supraconductrice.

Le brin est obtenu par étages successifs d'extrusion,de tréfilage et d'assemblage d'une multiplicité de tronçons coupés de l'élément obtenu après chaque opération de tréfilage.

Avec les matériaux utilisés, on observe que l'espacement entre deux filaments supraconducteurs dans un brin terminé doit être supérieur à environ 0,13 »m pour satisfaire aux conditions 2 et 3 énumérées ci-dessus. Cet espacement imposé réduit la proportion de supraconducteur et donc la densité de courant apparente, d'autant plus que les filaments supraconducteurs sont plus fins.

En pratique, il devient très pénalisant d'abaisser le diamètre des filaments en-dessous de 0,15 »m malgré le bénéfice important que ceci apporterait au point de vue des pertes et des densités de courant du supraconducteur seul.

L'invention a pour but de réaliser un brin supraconducteur destiné aux fréquences industrielles en utilisant des matériaux présentant à la fois des propriétés métallurgiques convenables pour la fabrication de filaments ultra-fins et des propriétés électriques permettant de réduire considérablement l'espacement nécessaire entre les filaments supraconducteurs, permettant ainsi d'obtenir un brin comportant un nombre accru de filaments avec un espacement réduit d'où des densités de courant apparentes fortement accrues, multipliées environ par deux et des pertes divisées environ par deux.

L'invention a ainsi pour objet un brin supraconducteur multifilamentaire destiné aux fréquences industrielles et réalisé par n étages successifs d'extrusion, de tréfilage et d'assemblage à partir d'une billette de départ en niobium-titane entourée d'une couche barrière anti-diffusion en niobium puis d'une matrice en alliage cupro-nickel, caractérisé par le fait qu'il comporte 5 x 10⁵ à 5 x 10⁶ filaments constitués chacun :
- d'une âme conductrice en niobium-titane, d'un diamètre compris entre cinquante et cent cinquante nanomètres,
- de ladite couche barrière anti-diffusion en niobium,

et par le fait que ladite matrice est en alliage cupro-nickel avec plus de 8 % de manganèse,
la distance séparant les brins les uns des autres étant comprise entre trente et cent nanomètres.

Selon une réalisation particulière, ledit alliage de cuivre comporte environ 12 % de manganèse et 2 % de nickel.
Un alliage de ce type est commercialement connu sous le nom "manganin".

L'invention a également pour objet un brin supraconducteur multifilamentaire destiné aux fréquences industrielles et réalisé par n étages successifs d'extrusion, de tréfilage et d'assemblage à partir d'une billette de départ en niobium-titane entourée d'une couche barrière anti-diffusion puis d'une matrice en alliage cupro-nickel,
caractérisé par le fait qu'il comporte 5 x 10⁵ à 5 x 10⁶ filaments constitués chacun :
- d'une âme conductrice en niobium-titane, d'un diamètre compris entre cinquante et cent cinquante nanomètres,
- d'une couche barrière antidiffusion en acier austénitique de type Fe - 30 % Ni - 20 % Cr-C-N,

la distance séparant les brins les uns des autres étant comprise entre trente et cent nanomètres.

L'invention va maintenant être décrite en se référant au dessin annexé dans lequel :

La figure 1 représente une section d'une billette de départ dans une première forme de réalisation de l'invention s'appliquant en régime alternatif.

La figure 2 représente une section très partielle d'un brin final supraconducteur réalisé à partir de la billette représentée figure 1.

La figure 3 représente une section d'une billette de départ dans une seconde forme de réalisation de l'invention.

La figure 4 représente une section très partielle d'un brin final supraconducteur réalisé à partir de la billette représentée figure 3.

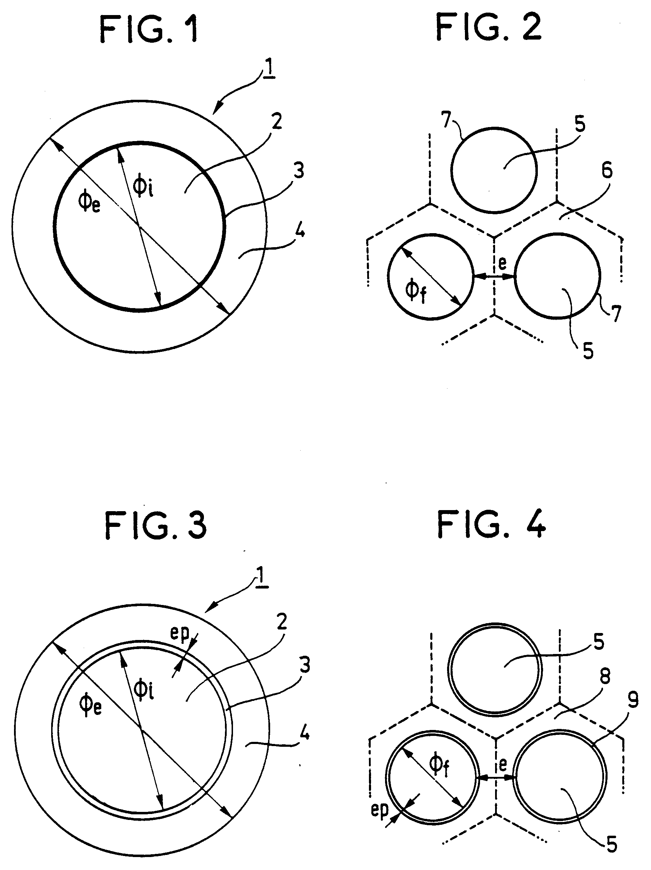

En se reportant à la figure 1, on voit une billette de départ 1 comportant une âme supraconductrice 2 qui peut être en niobium ou en alliage de niobium, par exemple un alliage niobium-titane.

Cette âme est entourée de deux couches de matériau de séparation : la première couche 3 en niobium constitue une barrière anti-diffusion de faible épaisseur, la seconde couche 4 est une couche relativement épaisse d'un alliage cuivreux comportant au moins 8 % de manganèse. Les essais effectués avec le produit commercialisé sous le nom de "manganin" qui est un alliage de cuivre avec 12 % de manganèse et 2 % de nickel ont donné de bons résultats. Le rapport du diamètre extérieur φₑ de la billette au diamètre φᵢ de l'âme 2 est d'environ 1,5, l'épaisseur de la couche 3 étant négligeable par rapport à l'âme 2 et à la couche 4.
A partir de cette billette, le brin, dont la figure 2 donne une section partielle, est réalisé selon la méthode connue par extrusion puis tréfilage. Le fil obtenu est ensuite coupé en tronçons qui sont assemblés en grand nombre dans une gaine en cupro-nickel de manière à recommencer une nouvelle fois l'opération d'extrusion puis de tréfilage. Le brin final est ainsi obtenu, par exemple, en trois étages successifs d'extrusion, et de tréfilage. Le brin terminé a un diamètre compris entre 0,1 et 0,4 mm, et a de 5.10⁵ à 5.10⁶ filaments supraconducteurs 5 qui sont constitués par l'âme supraconductrice 2 réduite à un diamètre φ_{f} compris entre cinquante et cent cinquante nonomètres séparés les uns des autres d'une distance e comprise entre trente et cent nanomètres. Le matériau de séparation 6 est essentiellement constitué par le "manganin" de la couche 4, chaque filament 5 étant entouré d'une fine couche barrière 7 en niobium.

Un tel brin donne de bons résultats en régime alternatif. La qualité recherchée pour réduire les effets de proximité est la présence de matériaux dont le magnéton de bohr est élevé : supérieur à quatre, et dont les spins magnétiques sont désordonnés pour éviter les pertes par hystérésis qu'induirait le ferromagnétisme dans le cas de spins ordonnés. Ces spins magnétiques réduisent la longueur de cohérence de l'état supraconducteur dans la couche 4 par diffusion magnétique.

Il avait été proposé déjà (cf l'article IEEE Transactions on Magnetics, Vol 24, No 2, March 1988), dans le cas d'une utilisation en régime lentement variable d'ajouter au cuivre de la couche extérieure 4 de 0,1 à 4 % de manganèse pour réduire les effets de proximité sur les brins composés de filaments de quelques microns, dont l'espacement était de l'ordre du micron. Dans ce cas, la teneur en manganèse doit être limitée étant donnée l'augmentation de la résistivité, défavorable à la stabilité.

Dans le cas de brins destinés aux fréquences industrielles, la stabilité est acquise par la taille très réduite des filaments supraconducteurs et du brin, une résistivité élevée de la couche extérieure 4 de séparation est recherchée. Des teneurs beaucoup plus élevées en manganèse ou en matériau présentant des propriétés comparables sont alors favorables, tant pour accroître la résistivité que pour réduire les effets de proximité.

Les figures 3 et 4 donnent un autre exemple de réalisation dans lequel on part d'une billette de départ 1 comportant une âme supraconductrice 2 en niobium-titane entourée d'une première couche 3 en acier austénitique stable non sujet à transformation martensitique lors de l'écrouissage durant les étapes d'étirage. On utilise par exemple l'alliage suivant : Fe - 30 % Ni - 20 % Cr - C-N.

On obtient ainsi une bonne ductilité, et l'absence de pertes ferromagnétiques. La résistivité est élevée. Les essais ont montré en outre qu'un tel matériau constituait une excellente barrière de diffusion. L'ensemble est entouré d'une seconde couche 4 en Cupro-nickel.

Le rapport du diamètre extérieur, φₑ , de la billette 1 au diamètre φᵢ de l'âme 2 est de l'ordre de 1,5 et le rapport de l'épaisseur ep de la couche 3 au diamètre φᵢ est de l'ordre de 0,05.

La figure 4 montre une section partielle du brin final de diamètre compris entre 0,1 et 0,4mm, dans lequel les filaments 5 ont un diamètre φ_{f} compris entre 50 et 150 nanomètres. La distance e entre les filaments 5 est comprise entre 30 et 100 nanomètres se répartissant entre le cupro-nickel 8 et l'acier austénitique 9 d'une épaisseur ep de l'ordre de 5 nanomètres.

Bien entendu l'invention n'est pas limitée aux exemples qui viennent d'être décrits.

## Revendications

1. Brin supraconducteur multifilamentaire destiné aux fréquences industrielles et réalisé par n étages successifs d'extrusion, de tréfilage et d'assemblage à partir d'une billette de départ en niobium-titane entourée d'une couche barrière anti-diffusion en niobium puis d'une matrice en alliage cupro-nickel,
caractérisé par le fait qu'il comporte 5 x 10⁵ à 5 x 10⁶ filaments constitués chacun :
- d'une âme conductrice en niobium-titane, d'un diamètre compris entre cinquante et cent cinquante nanomètres,
- de ladite couche barrière anti-diffusion en niobium (7),
et par le fait que ladite matrice (6) est en alliage cupro-nickel avec plus de 8 % de manganèse,
la distance séparant les brins les uns des autres étant comprise entre trente et cent nanomètres.

2. Brin supraconducteur selon la revendication 1, dans lequel ledit alliage de cuivre comporte environ 12 % de manganèse et 2 % de nickel.

3. Brin supraconducteur multifilamentaire destiné aux fréquences industrielles et réalisé par n étages successifs d'extrusion, de tréfilage et d'assemblage à partir d'une billette de départ en niobium-titane entourée d'une couche barrière anti-diffusion puis d'une matrice en alliage cupro-nickel,
caractérisé par le fait qu'il comporte 5 x 10⁵ à 5 x 10⁶ filaments constitués chacun :
- d'une âme conductrice en niobium-titane, d'un diamètre compris entre cinquante et cent cinquante nanomètres,
- d'une couche barrière antidiffusion (9) en acier austénitique de type Fe - 30 % Ni - 20 % Cr-C-N,
la distance séparant les brins les uns des autres étant comprise entre trente et cent nanomètres.

## Patentansprüche

1. Vielfädige supraleitende Ader für industrielle Frequenzen, die in n aufeinanderfolgenden Stufen der Extrusion, des Drahtziehens und des Zusammenbaus ausgehend von einem Ausgangsbarren aus Niobium-Titan umgeben von einer Diffusions-Barriereschicht aus Niobium und dann einer Matrix aus einer Kupfer-Nickellegierung hergestellt wird,
dadurch gekennzeichnet, daß sie 5 · 10⁵ bis 5 · 10⁶ Fäden enthält, die je aufweisen:
- eine leitende Seele aus Niobium-Titan mit einem Durchmesser von zwischen fünfzig und einhundertfünfzig Nanometern,
- die Diffusions-Barriereschicht aus Niobium, und daß die Matrix aus einer Kupfer-Nickellegierung ist, die mehr als 8% Mangan enthält, wobei der die Fäden voneinander trennende Abstand zwischen dreißig und einhundert Nanometern beträgt.

2. Supraleitende Ader nach Anspruch 1, bei der die Kupferlegierung etwa 12% Mangan und 2% Nickel enthält.

3. Vielfädige supraleitende Ader für industrielle Frequenzen, die in n aufeinanderfolgenden Stufen der Extrusion, des Drahtziehens und des Zusammenbaus ausgehend von einem Ausgangsbarren aus Niobium-Titan umgeben von einer Diffusions-Barriereschicht und dann einer Matrix aus einer Kupfer-Nickellegierung hergestellt wird,
dadurch gekennzeichnet, daß sie 5 · 10⁵ bis 5 · 10⁶ Fäden enthält, die je aufweisen:
- eine leitende Seele aus Niobium-Titan mit einem Durchmesser von zwischen fünfzig und einhundertfünfzig Nanometern,
- eine Diffusions-Barriereschicht aus Austenitstahl der Art Fe - 30% Ni - 20% Cr-C-N,
wobei der die Fäden voneinander trennende Abstand zwischen dreißig und einhundert Nanometern beträgt.

## Claims

1. A multifilament superconducting strand for use at industrial frequencies and made by n successive stages of extrusion, wire-drawing, and assembly, from an initial billet made of an alloy of niobium and titanium surrounded by an antidiffusion barrier layer made of niobium and then by a matrix made of a cupronickel alloy, the strand being characterized by the fact that it includes 5 x 10⁵ to 5 x 10⁶ filaments each constituted:
of a conducting core made of niobium and titanium alloy, with a diameter in the range fifty nanometers to one hundred and fifty nanometers;
of said antidiffusion barrier layer (7) made of niobium, and by the fact that said matrix (6) is made of a cupronickel alloy with not less than 8% manganese;
the distance separating the strands from one another lying in the range thirty nanometers to one hundred nanometers.

2. A superconducting strand according to claim 1, in which said copper alloy includes about 12% manganese and about 2% nickel.

3. A multifilament superconducting strand for use at industrial frequencies and made by n successive stages of extrusion, wire-drawing, and assembly, from an initial billet made of an alloy of niobium and titanium surrounded by an antidiffusion barrier layer, and then by a matrix made of a cupronickel alloy, the strand being characterized by the fact that it includes 5 x 10⁵ to 5 x 10⁶ filaments each constituted:
of a conducting core made of niobium and titanium alloy, with a diameter in the range fifty nanometers to one hundred and fifty nanometers;
of an antidiffusion barrier layer (9) made of austenitic steel of the type Fe-30%Ni-20%Cr-C-N;
the distance separating the strands from one another lying in the range thirty nanometers to one hundred nanometers.
